# EUROPÄISCHE PATENTSCHRIFT

(11) **EP 2 067 390 B1**
(45) Veröffentlichungstag und Bekanntmachung des Hinweises auf die Patenterteilung: **28.01.2015**
(21) Anmeldenummer: 07817560.1
(22) Anmeldetag: 21.09.2007
(51) Int. Cl.: H05K 1/14, H05K 1/03, H05K 3/30, H05K 3/34

(54) **VERFAHREN ZUR HERSTELLUNG EINER ANORDNUNG OPTOELEKTRONISCHER BAUELEMENTE UND ANORDNUNG OPTOELEKTRONISCHER BAUELEMENTE**
METHOD FOR PRODUCING AN ARRANGEMENT OF OPTOELECTRONIC COMPONENTS, AND ARRANGEMENT OF OPTOELECTRONIC COMPONENTS
PROCÉDÉ DE FABRICATION D'UN AGENCEMENT DE COMPOSANTS OPTOÉLECTRONIQUES ET AGENCEMENT DE COMPOSANTS OPTOÉLECTRONIQUES

(30) Priorität: 25.09.2006 DE 102006045129; 14.12.2006 DE 102006059127
(43) Veröffentlichungstag der Anmeldung: 10.06.2009
(73) Patentinhaber: OSRAM Opto Semiconductors GmbH, 93055 Regensburg (DE)
(72) Erfinder: SEWALD, Rainer, 84416 Taufkirchen (DE); KIRSCH, Markus, 93164 Brunn (DE)
(74) Vertreter: Epping - Hermann - Fischer
(86) Internationale Anmeldenummer: PCT/DE2007/001714
(87) Internationale Veröffentlichungsnummer: WO 2008/040307

(56) Entgegenhaltungen:
- WO-A-2005/083803
- DE-A1- 2 528 000
- JP-A- 2006 059 883
- US-A- 4 417 296
- US-A- 5 109 269
- US-A1- 2006 105 607

## Beschreibung

Es wird ein Verfahren zur Herstellung einer Anordnung optoelektronischer Bauelemente angegeben. Darüber hinaus wird eine Anordnung optoelektronischer Bauelemente angegeben.

Die Druckschrift WO 2005/083803 beschreibt eine Anordnung optoelektronischer Bauelemente.

Die Druckschrift DE 25 28 000 A1 beschreibt ein Verfahren zur Herstellung einer Lötfläche relativ großer Abmessung.

Die Druckschriften US 4,417,296 und US 5,109,269 beschreiben Verfahren zur Verbindung eines oberflächenmontierbaren Bauteils mit einer Leiterplatte.

Weitere optoelektronische Bauelemente sowie Verfahren zu deren Herstellung sind in den Druckschriften US 2006/0105607 und JP 2006/059883 beschrieben.

Eine zu lösende Aufgabe besteht darin, ein Verfahren zur Herstellung einer Anordnung optoelektronischer Bauelemente anzugeben, das besonders kostengünstig durchführbar ist. Eine weitere zu lösende Aufgabe besteht darin, eine Anordnung optoelektronischer Bauelemente anzugeben, die mit dem Verfahren hergestellt ist.

Die Erfindung betrifft ein Verfahren gemäß Anspruch 1 sowie eine Anordnung optoelektronischer Bauelemente gemäß Anspruch 11.

Gemäß zumindest einer Ausführungsform des Verfahrens zur Herstellung einer Anordnung optoelektronischer Bauelemente werden zumindest zwei Befestigungsbereiche auf einem ersten Anschlussträger hergestellt. Die Befestigungsbereiche werden vorzugsweise auf der Oberfläche des ersten Anschlussträgers angeordnet. Die Befestigungsbereiche sind zum Beispiel zur Aufnahme eines Befestigungsmateriales geeignet. Bei dem Befestigungsmaterial handelt es sich vorzugsweise um ein Lotmaterial. Die Befestigungsbereiche sind vorzugsweise räumlich voneinander getrennt, das heißt die Befestigungsbereiche überlappen einander nicht.

Bei dem ersten Anschlussträger handelt es sich zum Beispiel um eine Leiterplatte, die einen Grundkörper aufweist sowie Leiterbahnen, die Anschlussstellen der Leiterplatte elektrisch leitend miteinander verbinden. Beispielsweise handelt es sich bei dem ersten Anschlussträger um eine Metallkernplatine.

Gemäß zumindest einer Ausführungsform des Verfahrens zur Herstellung einer Anordnung optoelektronischer Bauelemente wird in einem weiteren Verfahrensschritt ein Befestigungsmaterial - vorzugsweise ein Lotmaterial - in die Befestigungsbereiche eingebracht. Die Befestigungsbereiche sind dabei vorzugsweise derart ausgebildet, dass sie das Lotmaterial lokal binden. Das heißt das Lotmaterial haftet an oder in den Befestigungsbereichen und verläuft beim Aufschmelzen nicht. Insbesondere verbindet sich das Lotmaterial in einem Befestigungsbereich nicht mit dem Lotmaterial in einem anderen Befestigungsbereich des ersten Anschlussträgers.

Gemäß zumindest einer Ausführungsform des Verfahrens zur Herstellung einer Anordnung optoelektronischer Bauelemente wird in einem weiteren Verfahrensschritt ein zweiter Anschlussträger auf die Befestigungsbereiche aufgebracht. Bei dem zweiten Anschlussträger handelt es sich um eine Leiterplatte. Die Leiterplatte kann zum Beispiel als Metallkernplatine oder als Leiterplatte mit einem keramischen Grundkörper, auf den Leiterbahnen und Anschlussstellen strukturiert sind, ausgebildet sein.

Gemäß zumindest einer Ausführungsform des Verfahrens zur Herstellung einer Anordnung optoelektronischer Bauelemente wird in einem nachfolgenden Verfahrensschritt der zweite Anschlussträger mittels des Befestigungsmaterials mit dem ersten Anschlussträger mechanisch verbunden. Handelt es sich bei dem Befestigungsmaterial um ein Lotmaterial, so wird der zweite Anschlussträger auf den ersten Anschlussträger mit dem Lotmaterial in den Befestigungsbereichen aufgelötet. Das Lotmaterial in den Befestigungsbereichen stellt dabei vorzugsweise eine thermische und mechanische Verbindung zwischen den beiden Anschlussträgern her. Bevorzugt wird der zweite Anschlussträger durch das Lotmaterial nicht mit dem ersten Anschlussträger elektrisch kontaktiert. Das heißt das Lotmaterial der Befestigungsbereiche ist nicht zur Kontaktierung oder Stromführung vorgesehen.

Gemäß zumindest einer Ausführungsform des Verfahrens zur Herstellung einer Anordnung von optoelektronischen Bauelementen weist das Verfahren die folgenden Schritte auf:
- Zunächst werden zumindest zwei Befestigungsbereiche auf einem ersten Anschlussträger hergestellt.
- Nachfolgend wird Lotmaterial in die Befestigungsbereiche auf dem ersten Anschlussträger eingebracht.
- Danach wird ein zweiter Anschlussträger auf die Befestigungsbereiche des ersten Anschlussträgers aufgebracht und mit dem Lotmaterial in den Befestigungsbereichen auf den ersten Anschlussträger aufgelötet.

Der zweite Anschlussträger weist dabei vorzugsweise eine lateral kleinere Ausdehnung als der erste Anschlussträger auf. Das bedeutet beispielsweise, dass der zweite Anschlussträger vorzugsweise - nachdem er auf den ersten Anschlussträger aufgelötet ist - diesen lateral nicht überragt, sondern höchstens bündig mit einem Rand des ersten Anschlussträgers abschließt.

Bei einer derart hergestellten Anordnung optoelektronischer Bauelemente handelt es sich zum Beispiel um eine Leuchtdiodenanordnung, eine Laserdiodenanordnung oder eine Fotodetektoranordnung. Das hier beschriebene Verfahren macht sich dabei unter anderem die Idee zu Nutze, dass eine mit dem Verfahren hergestellte Anordnung optoelektronischer Bauelemente besonders gute thermische Eigenschaften aufweist, da das Lotmaterial in den Befestigungsbereichen den thermischen Gesamtwiderstand des Bauelements absenkt. Weiter ist die Lebensdauer der Anordnung aufgrund der hohen mechanischen Belastbarkeit des Lotmaterials besonders hoch. Die Anordnung optoelektronischer Bauelemente eignet sich daher besonders gut für eine Verwendung in Kraftfahrzeugen, da sie auch größeren mechanischen Belastungen über lange Zeiten Stand hält, ohne beschädigt zu werden. Aufgrund der Strukturierung der Lotverbindung - das heißt das Einbringen des Lotmaterials in Befestigungsbereiche, die räumlich voneinander getrennt sind - können thermische Spannungen, die zwischen ersten und zweiten Anschlussträger auftreten, besonders gut ausgeglichen werden. Weiter ist bei einer Verbindung der zwei Anschlussträger durch Lotmaterial in mehreren Befestigungsbereichen die Wahrscheinlichkeit, dass die Verbindung zwischen dem ersten und dem zweiten Anschlussträger aufbricht - das heißt die Wahrscheinlichkeit dafür, dass sämtliche Lotverbindungen aufbrechen - relativ gering.

Weiter ermöglichen die vor dem Aufbringen des Befestigungsmaterials hergestellten Befestigungsbereiche, eine Eigenzentrierung des zweiten Anschlussträgers bei Aufbringung auf den ersten Anschlussträger. So können für die Herstellung der Anordnung optoelektronischer Bauelemente Maschinen Verwendung finden, die eine relativ hohe Ablagetoleranz aufweisen und damit kostengünstig sind. Außerdem können diese Maschinen dann mit einem hohen Durchsatz arbeiten. Insgesamt ist mit dem beschriebenen Verfahren eine kostengünstige Herstellung von Anordnungen optoelektronischer Bauelemente ermöglicht.

Gemäß zumindest einer Ausführungsform des Verfahrens wird zumindest ein Befestigungsbereich durch das Erzeugen einer Ausnehmung im ersten Anschlussträger hergestellt. Vorzugsweise werden dann alle Befestigungsbereiche auf diese Art erzeugt. Die Strukturierung des ersten Anschlussträgers erfolgt also auf mechanische und/oder chemische Art, beispielsweise durch eine der folgenden Techniken: Prägen, Fräsen, Erodieren, Ätzen. Durch diese Techniken werden Ausnehmungen im ersten Anschlussträger erzeugt, wobei jede der Ausnehmungen einen Befestigungsbereich bildet.

Gemäß zumindest einer Ausführungsform des Verfahrens wird zumindest ein Befestigungsbereich durch die Strukturierung einer Lötstoppschicht, die auf den ersten Anschlussträger aufgebracht ist, hergestellt. Dazu wird beispielsweise zunächst ein Lötstopplack auf eine Oberfläche des ersten Anschlussträgers aufgebracht und mittels einer Fototechnik strukturiert. Die mittels der Fototechnik in den Lötstopplack strukturierten Ausnehmungen bilden dann die Befestigungsbereiche, die im folgenden Verlauf des Verfahrens das Lotmaterial aufnehmen.

Gemäß zumindest einer Ausführungsform des Verfahrens wird zunächst ein Befestigungsbereich durch das Aufbringen einer Metallisierung auf den ersten Anschlussträger hergestellt. Die Metallisierung wird dabei strukturiert auf den ersten Anschlussträger aufgebracht, so dass die metallisierten Bereiche die Befestigungsbereiche bilden. Die Metallisierung enthält oder besteht aus einem durch Lotmaterial benetzbarem Metall wie zum Beispiel Gold, Silber, Palladium, Nickel, Palladium/Nickel-Legierung, Zinn, Zinn-Legierungen oder Kombinationen dieser Metalle. Die Metallisierung wird zum Beispiel mittels eines chemischen, elektrolytischen und/oder physikalischen Beschichtungsverfahrens wie einem PVD-Beschichtungsverfahren auf den ersten Anschlussträger aufgebracht.

Gemäß zumindest einer Ausführungsform des Verfahrens werden die Befestigungsbereiche matrixartig auf den ersten Anschlussträger ausgebildet. Das heißt mehrere Befestigungsbereiche werden in Zeilen und Spalten angeordnet.

Gemäß zumindest einer Ausführungsform des Verfahrens werden auf den zweiten Anschlussträger Befestigungsbereiche in gleicher Weise wie für den ersten Anschlussträger erzeugt. Das heißt zumindest ein Befestigungsbereich kann durch das Erzeugen einer Ausnehmung im zweiten Anschlussträger hergestellt werden. Zumindest ein Befestigungsbereich kann durch das Aufbringen einer Metallisierung auf den zweiten Anschlussträger hergestellt werden. Zumindest ein Befestigungsbereich kann das Strukturieren einer Lötstoppschicht, die auf den zweiten Anschlussträger aufgebracht ist, hergestellt werden. Die Befestigungsbereiche können dabei matrixartig auf den zweiten Anschlussträger angeordnet werden. Dabei ist es insbesondere vorteilhaft, wenn jedem Befestigungsbereich des zweiten Anschlussträgers ein Befestigungsbereich des ersten Anschlussträgers eindeutig oder eineindeutig zugeordnet ist. Die Eintragung von Lotmaterial kann vor dem Lötvorgang in die Befestigungsbereiche des ersten und/oder des zweiten Anschlussträgers erfolgen.

Es ist aber auch möglich, dass auf den zweiten Anschlussträger keine Befestigungsbereiche erzeugt werden. Die dem ersten Anschlussträger zugewandte Seite des zweiten Anschlussträgers bleibt dann unstrukturiert und ist frei von Befestigungsbereichen.

Gemäß zumindest einer Ausführungsform des Verfahrens wird das Lotmaterial in den Befestigungsbereichen vor dem Aufbringen und Auflöten des zweiten Anschlussträgers planarisiert. Dazu kann das Lot in den Befestigungsbereichen aufgeschmolzen und/oder mit Druck - zum Beispiel mittels eines Stempels - planarisiert werden. Anschließend kann eine Flussmitteleintragung durch Stempeln oder Dispensieren auf die einzelnen Befestigungsbereiche, die das planarisierte Lotmaterial enthalten, erfolgen. Der Umschmelz- und Planarisierungsschritt kann bei der Verwendung einer mit Flussmittel versetzten Lotpaste, die beispielsweise über Dispensen, Stempeln, Drucken, Rakeln aufgebracht wird, entfallen. In diesem Fall wird der zweite Anschlussträger direkt in die Lotpaste gesetzt und aufgelötet.

Gemäß zumindest einer Ausführungsform des Verfahrens wird zwischen dem ersten und dem zweiten Anschlussträger ein Füllmaterial eingebracht, welches das Lotmaterial zumindest stellenweise seitlich umhüllt. Dabei kann das Füllmaterial vor oder nach dem Aufbringen des zweiten Anschlussträgers auf den ersten Anschlussträger in den Befestigungsbereich eingebracht werden.

Gemäß zumindest einer Ausführungsform des Verfahrens ist das Füllmaterial nicht adhäsiv, das heißt es vermittelt keine mechanische Verbindung zwischen den beiden Anschlussträgern. Das Füllmaterial ist vorzugsweise thermisch gut leitend und verbessert die thermische Verbindung zwischen den beiden Anschlussträgern zusätzlich zum Lotmaterial. Als nicht adhäsive Füllmaterialien eignen sich zum Beispiel Wärmeleitpasten auf Keramik- oder Silberpartikelbasis.

Gemäß zumindest einer Ausführungsform des Verfahrens ist das Füllmaterial adhäsiv, das heißt es vermittelt zusätzlich zum Lotmaterial eine mechanische Verbindung zwischen den beiden Anschlussträgern. Das Füllmaterial ist vorzugsweise thermisch gut leitend und verbessert die thermische Verbindung zwischen den beiden Anschlussträgern zusätzlich zum Lotmaterial. Als adhäsive Füllmaterialien eignen sich zum Beispiel Wärmeleitkleber auf Keramik- oder Silberpartikelbasis.

Gemäß zumindest einer Ausführungsform des Verfahrens wird vor dem Aufbringen des zweiten Anschlussträgers - insbesondere vor dem Auflöten des zweiten Anschlussträgers - zumindest ein optoelektronisches Bauelement - zum Beispiel ein optoelektronischer Halbleiterchip wie ein Leuchtdiodenchip, ein Laserdiodenchip oder ein Fotodetektorchip - auf einen Chipanschlussbereich des zweiten Anschlussträgers aufgebracht. Das bedeutet, es wird ein bereits mit optoelektronischen Halbleiterchips bestückter zweiter Anschlussträger auf den ersten Anschlussträger aufgelötet.

Es wird ferner eine Anordnung optoelektronischer Bauelemente nach Anspruch 11 angegeben.

Gemäß zumindest einer Ausführungsform der Anordnung umfasst die Anordnung einen ersten Anschlussträger, der zumindest zwei Befestigungsbereiche aufweist, in die ein Lotmaterial eingebracht ist. Die Befestigungsbereiche sind vorzugsweise auf der Oberfläche des ersten Anschlussträgers angeordnet. Die Befestigungsbereiche sind vorzugsweise räumlich voneinander getrennt, das heißt die Befestigungsbereiche überlappen einander nicht. Die Befestigungsbereiche sind dabei vorzugsweise derart ausgebildet, dass sie das Lotmaterial lokal binden. Das heißt das Lotmaterial haftet an oder in den Befestigungsbereichen. Insbesondere ist das Lotmaterial in einem Befestigungsbereich nicht mit dem Lotmaterial in einem anderen Befestigungsbereich des ersten Anschlussträgers verbunden.

Bei dem ersten Anschlussträger handelt es sich zum Beispiel um eine Leiterplatte, die einen Grundkörper aufweist sowie Leiterbahnen, die Anschlussstellen der Leiterplatte elektrisch leitend miteinander verbinden. Beispielsweise handelt es sich bei dem ersten Anschlussträger um eine Metallkernplatine.

Erfindungsgemäß umfasst die Anordnung weitere einen zweiten Anschlussträger, der durch das Lotmaterial in den Befestigungsbereichen mechanisch mit dem ersten Anschlussträger verbunden ist. Bei dem zweiten Anschlussträger handelt es sich um eine Leiterplatte. Die Leiterplatte kann zum Beispiel als Metallkernplatine oder als Leiterplatte mit einem keramischen Grundkörper, auf den Leiterbahnen und Anschlussstellen strukturiert sind, ausgebildet sein.

Gemäß zumindest.einer Ausführungsform der Anordnung optoelektronischer Bauelemente umfasst die Anordnung zumindest ein optoelektronisches Bauelement - zum Beispiel einen optoelektronischen Halbleiterchip - das auf die dem ersten Anschlussträger abgewandten Seite des zweiten Anschlussträgers aufgebracht ist. Dabei ist das optoelektronische Bauelement vorzugsweise vor dem Auflöten des zweiten Anschlussträgers auf den ersten Anschlussträger auf dem zweiten Anschlussträger befestigt worden. Bei dem optoelektronischen Bauelement handelt es sich zum Beispiel um einen der folgenden Halbleiterchips: Leuchtdiodenchip, Laserdiodenchip, Fotodetektorchip.

Gemäß zumindest einer Ausführungsform der Anordnung optoelektronischer Bauelemente umfasst die Anordnung die folgenden Komponenten:
- einen ersten Anschlussträger, der zumindest zwei Befestigungsbereiche aufweist, in die ein Lotmaterial eingebracht ist,
- einen zweiten Anschlussträger, der durch das Lotmaterial in den Befestigungsbereichen mechanisch mit dem ersten Anschlussträger verbunden ist, und
- zumindest ein optoelektronisches Bauelement, das auf die dem ersten Anschlussträger abgewandte Seite des zweiten Anschlussträgers aufgebracht ist.

Gemäß zumindest einer Ausführungsform der Anordnung optoelektronischer Bauelemente ist das Lotmaterial in den Befestigungsbereichen nicht zum elektrischen Anschließen der optischen Halbleiterchips vorgesehen. Das bedeutet, das Lotmaterial dient nicht zur Stromführung zwischen dem ersten Anschlussträger und dem zweiten Anschlussträger, sondern vermittelt eine thermische und mechanische Verbindung zwischen diesen beiden Anschlussträgern. Der Anschluss der Halbleiterchips an den ersten Anschlussträger kann beispielsweise mittels Drahtkontakten oder extra Lotverbindungen erfolgen, die nicht in einem Befestigungsbereich des ersten Anschlussträgers angeordnet sind.

Gemäß zumindest einer Ausführungsform sind Befestigungsbereiche des ersten Anschlussträgers matrixartig angeordnet. Das heißt die Befestigungsbereiche sind in Zeilen und Spalten angeordnet. Beispielsweise weist die Umhüllende aller Befestigungsbereiche des ersten Anschlussträgers eine rechteckige oder quadratische Form auf. Prinzipiell sind für die Umhüllende aber alle zweidimensionalen Geometrien, insbesondere auch kreisförmige oder dreieckige Umhüllende möglich.

Gemäß zumindest einer Ausführungsform der Anordnung optoelektronischer Bauelemente befindet sich zwischen dem ersten Anschlussträger und dem zweiten Anschlussträger ein Füllmaterial, welches das Lotmaterial zumindest stellenweise seitlich umhüllt. Vorzugsweise umhüllt das Füllmaterial das Lotmaterial seitlich vollständig. Das heißt, der Raum zwischen dem ersten und dem zweiten Anschlussträger ist dann vollständig befüllt mit Lotmaterial und dem Füllmaterial. Bei dem Füllmaterial handelt es sich um ein thermisch gut leitendes Material, das zusätzlich zum Lotmaterial eine thermische Verbindung zwischen dem ersten Anschlussträger und dem zweiten Anschlussträger vermittelt. Das Füllmaterial ist dabei beispielsweise nicht adhäsiv, so dass es keine mechanische Verbindung zwischen dem ersten Anschlussträger und dem zweiten Anschlussträger vermittelt. Es ist aber auch möglich, dass das Füllmaterial adhäsiv ist und zusätzlich zum Lotmaterial eine weitere mechanische Verbindung zwischen den Anschlussträgern vermittelt.

Gemäß zumindest einer Ausführungsform der Anordnung optoelektronischer Bauelemente weist der zweite Anschlussträger einen Grundkörper auf, der aus einem keramischen Material besteht oder eine keramisches Material enthält. Beispielsweise enthält oder besteht der Grundkörper aus zumindest einem der folgenden Materialien: ein AluminiumNitrid, Glas, polykristallines Al₂O₃, monokristallines A₂O₃, Silizium. Auf dem Grundkörper des zweiten Anschlussträgers sind Anschlussstellen sowie Leiterbahnen strukturiert.

Im Folgenden werden das hier beschriebene Verfahren sowie die hier beschriebene Anordnung optoelektronischer Bauelemente anhand von Ausführungsbeispielen und den dazugehörigen
Figuren näher erläutert.
- Figuren 1A, 1B, 1C, 1D, 1E: zeigen schematische Perspektivdarstellungen, anhand derer ein erstes Ausführungsbeispiel eines hier beschriebenen Verfahrens näher erläutert ist.
- In den Figuren 2A, 2B, 2C, 2D und 2E: ist anhand schematischer Perspektivdarstellungen ein zweites Ausführungsbeispiel eines hier beschriebenen Verfahrens zur Herstellung einer Anordnung optoelektronischer Bauelemente erläutert.
- In den Figuren 3A, 3B, 3C sowie 3D: ist anhand schematischer Perspektivdarstellungen ein drittes Ausführungsbeispiel eines hier beschriebenen Verfahrens zur Herstellung einer Anordnung optoelektronischer Bauelemente erläutert.
- Figur 4: zeigt in einer schematischen Schnittdarstellung eine hier beschriebene Anordnung optoelektronischer Bauelemente entlang des Schnittes AA', wie er in Figur 3D gezeigt ist.

In den Ausführungsbeispielen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

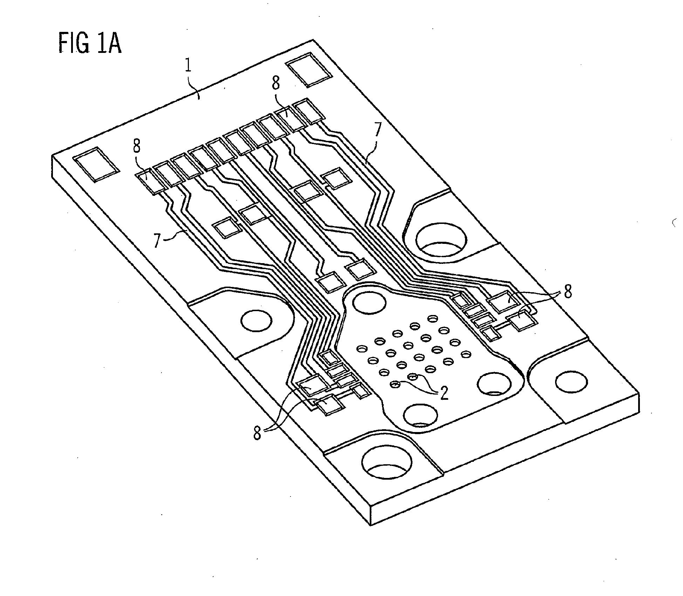

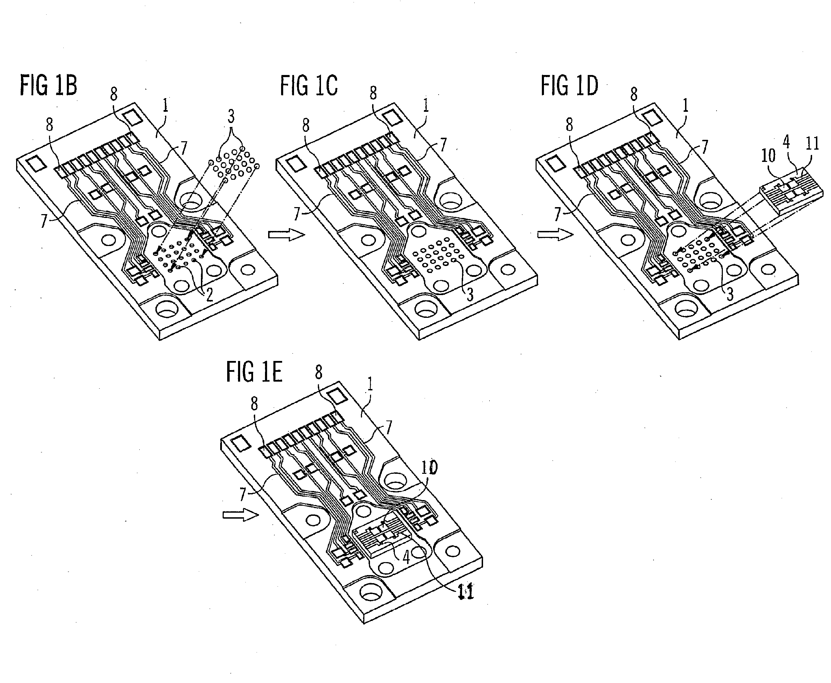

Die Figuren 1A, 1B, 1C, 1D, 1E zeigen schematische Perspektivdarstellungen, anhand derer ein erstes Ausführungsbeispiel eines hier beschriebenen Verfahrens näher erläutert ist.

Die Figur 1A zeigt eine schematische Perspektivdarstellung eines ersten Anschlussträgers 1. Der erste Anschlussträger 1 weist eine Vielzahl von Leiterbahnen 7 auf, die Anschlussstellen 8 des Anschlussträgers 1 elektrisch leitend miteinander verbinden. Bei dem ersten Anschlussträger 1 handelt es sich beispielsweise um eine Metallkernplatine.

Der Anschlussträger 1 weist eine Vielzahl von Befestigungsbereichen 2 auf. Die Befestigungsbereiche 2 sind matrixartig angeordnet. Im vorliegenden Ausführungsbeispiel sind die Befestigungsbereiche 2 in vier Zeilen zu je fünf Spalten angeordnet. Die Befestigungsbereiche 2 sind durch Ausnehmungen im ersten Anschlussträger 1 gebildet. Die Ausnehmungen sind chemisch und/oder mechanisch erzeugt, beispielsweise durch eine der folgenden Techniken: Prägen, Fräsen, Erodieren, Ätzen. Durch diese Techniken werden Ausnehmungen im ersten Anschlussträger erzeugt, welche jeweils einen Befestigungsbereich 2 bilden.

Anhand der Figur 1B ist ein nächster Verfahrensschritt eines ersten Ausführungsbeispiels eines hier beschriebenen Verfahrens zur Herstellung einer Anordnung optoelektronischer Bauelemente beschrieben. In diesem Verfahrensschritt wird Lotmaterial 3 - vorliegend in Form von Lotkugeln - in die Befestigungsbereiche 2 eingebracht. Dabei wird das Lotmaterial 3 in den durch Ausnehmungen gebildeten Befestigungsbereichen 2 versenkt.

In Verbindung mit der Figur 1C ist ein weiterer Verfahrensschritt erläutert. In diesem Verfahrensschritt wird das Lotmaterial 3 umgeschmolzen und planarisiert. Zum Planarisieren kann beispielsweise ein Stempel Verwendung finden.

In Verbindung mit der Figur 1D ist ein weiterer Verfahrensschritt des ersten Ausführungsbeispiels eines hier beschriebenen Verfahrens erläutert. In diesem Verfahrensschritt wird ein zweiter Anschlussträger 4 auf die Befestigungsbereiche 2 mit dem Lotmaterial 3 aufgebracht. Bei dem zweiten Anschlussträger 4 handelt es sich vorliegend um einen Anschlussträger mit einem keramischen Grundkörper, auf dem Leiterbahnen 11 strukturiert sind. Auf den zweiten Anschlussträger 4 sind bereits optoelektronische Bauelemente 10 - vorliegend Leuchtdiodenchips - aufgebracht.

Figur 1E erläutert einen weiteren Verfahrensschritt des ersten Ausführungsbeispiels eines hier beschriebenen Verfahrens zur Herstellung einer Anordnung optoelektronischer Bauelemente. In diesem Verfahrensschritt wird der aufgesetzte zweite Anschlussträger 4 mit Flussmittel fixiert und beispielsweise mittels einer Reflow-Löttechnik auf den ersten Anschlussträger 1 aufgelötet. Dabei wird die mechanische Verbindung zwischen dem ersten Anschlussträger 1 und dem zweiten Anschlussträger 4 durch das Lotmaterial in den Befestigungsbereichen 2 hergestellt.

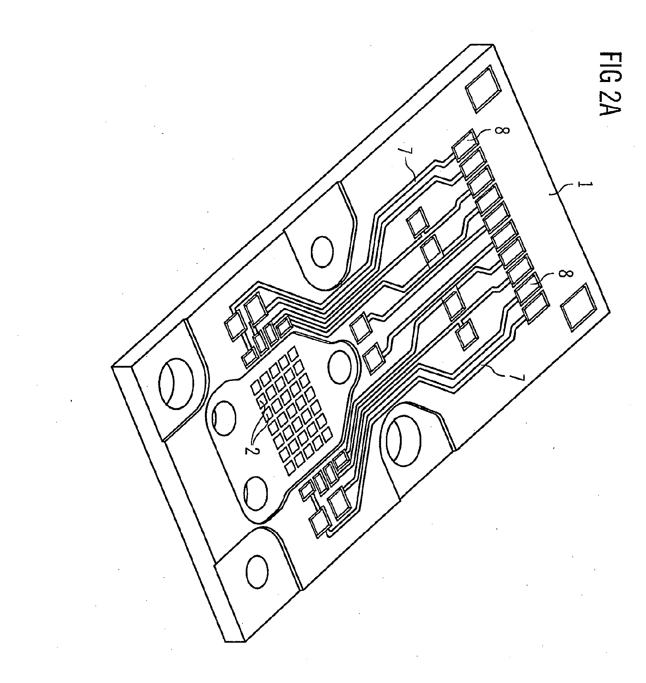

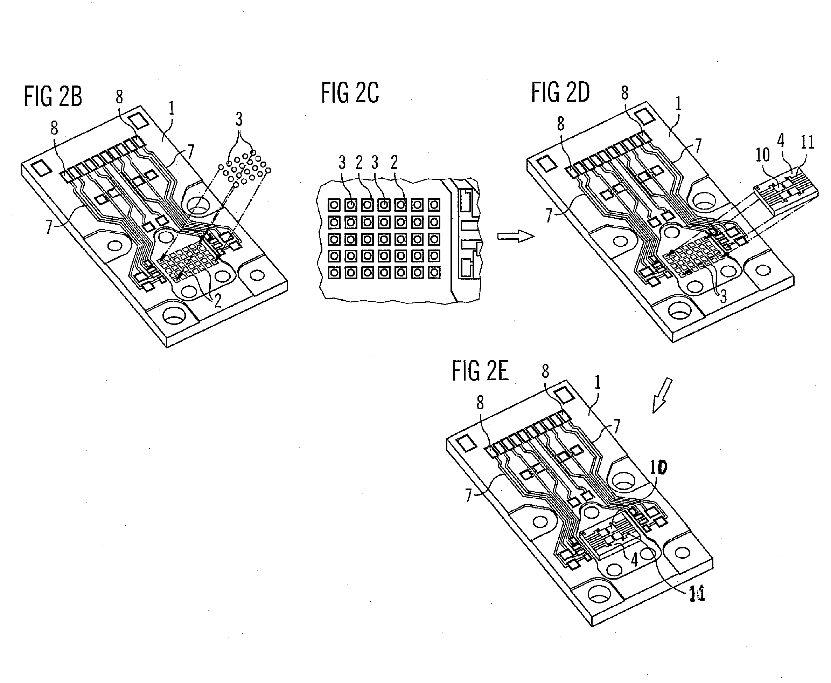

In den Figuren 2A, 2B, 2C, 2D und 2E ist anhand schematischer Perspektivdarstellungen ein zweites Ausführungsbeispiel eines hier beschriebenen Verfahrens zur Herstellung einer Anordnung optoelektronischer Bauelemente erläutert. Im Unterschied zum in Verbindung mit den Figuren 1A bis 1E beschriebenen Ausführungsbeispiel sind die Befestigungsbereiche 2 in diesem Ausführungsbeispiel durch Metallisierungen der Oberfläche des ersten Anschlussträgers 1 gebildet. Die Metallisierungen werden dabei strukturiert auf den ersten Anschlussträger aufgebracht, so dass die metallisierten Bereiche die Befestigungsbereiche 2 bilden. Die Metallisierungen enthalten oder bestehen aus einem durch Lotmaterial benetzbarem Metall wie zum Beispiel Gold, Silber, Palladium, Nickel, Palladium/Nickel-Legierung, Zinn, Zinn-Legierungen oder Kombinationen dieser Metalle. Die Metallisierungen werden zum Beispiel mittels eines chemischen, elektrolytischen und/oder physikalischen Beschichtungsverfahrens wie PVD auf den ersten Anschlussträger aufgebracht.

In der schematischen Perspektivdarstellung der Figur 2B ist gezeigt, dass Lotmaterial 3 in die durch die Metallisierungen gebildeten Befestigungsbereiche 2 eingebracht wird.

Anhand der schematischen Draufsicht der Figur 2C ist erläutert, dass in einem nachfolgenden Verfahrensschritt des zweiten Ausführungsbeispiels eines hier beschriebenen Verfahrens das Lotmaterial umgeschmolzen und planarisiert wird. Das Lotmaterial 3 verbleibt dabei in den Befestigungsbereichen 2. Das heißt das Lotmaterial 3 unterschiedlicher Befestigungsbereiche 2 verläuft nicht zu einem einzigen, größeren Lotklumpen sondern bleibt getrennt voneinander.

In Verbindung mit der Figur 2D ist ein weiterer Verfahrensschritt des zweiten Ausführungsbeispiels eines hier beschriebenen Verfahrens erläutert. In diesem Verfahrensschritt wird ein zweiter Anschlussträger 4 auf die Befestigungsbereiche 2 mit dem Lotmaterial 3 aufgebracht. Bei dem zweiten Anschlussträger 4 handelt es sich vorliegend um einen Anschlussträger mit einem keramischen Grundkörper, auf dem Leiterbahnen 11 strukturiert sind. Auf den zweiten Anschlussträger 4 sind optoelektronische Bauelemente 10-vorliegend Leuchtdiodenchips - bereits aufgebracht.

Figur 2E erläutert einen weiteren Verfahrensschritt des zweiten Ausführungsbeispiels eines hier beschriebenen Verfahrens zur Herstellung einer Anordnung optoelektronischer Bauelemente. In diesem Verfahrensschritt wird der aufgesetzte zweite Anschlussträger 4 mit Flussmittel fixiert und beispielsweise mittels einer Reflow-Löttechnik auf den ersten Anschlussträger 1 aufgelötet. Dabei wird die mechanische Verbindung zwischen dem ersten Anschlussträger 1 und dem zweiten Anschlussträger 4 durch das Lotmaterial in den Befestigungsbereichen 2 vermittelt.

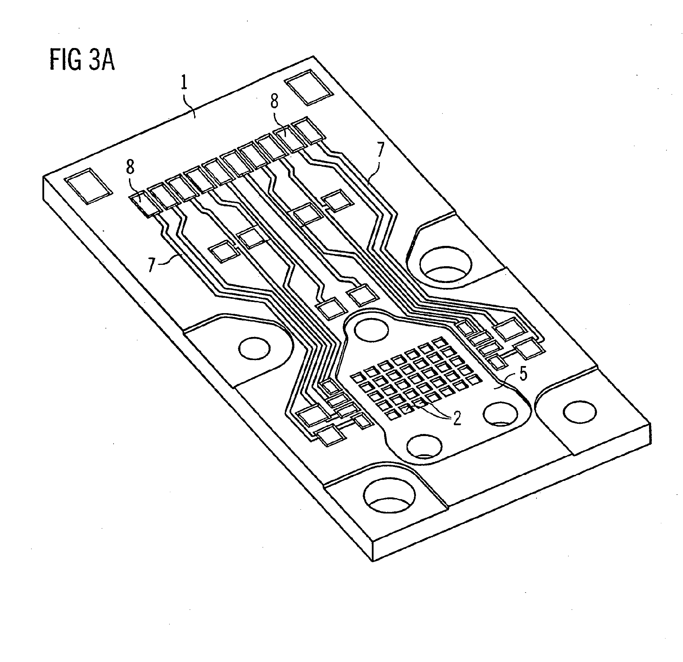

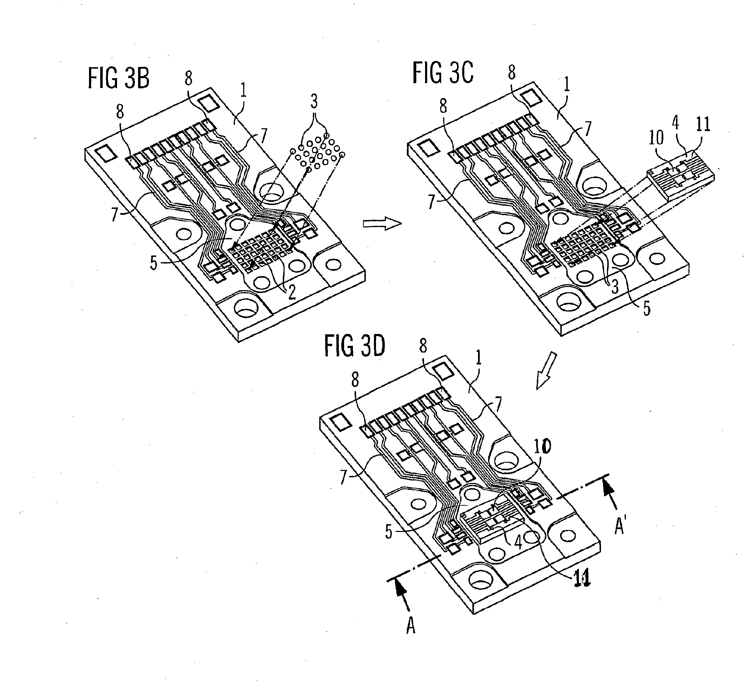

In den Figuren 3A, 3B, 3C sowie 3D ist anhand schematischer Perspektivdarstellungen ein drittes Ausführungsbeispiel eines hier beschriebenen Verfahrens zur Herstellung einer Anordnung optoelektronischer Bauelemente erläutert. Im Unterschied zu den in Verbindung mit den Figuren 1A bis 1E beziehungsweise 2A bis 2E beschriebenen Ausführungsbeispielen sind die Befestigungsbereiche 2 in diesem Ausführungsbeispiel durch Ausnehmungen in einer Lötstopplackschicht 5 gebildet. Dazu wird beispielsweise zunächst eine Lötstopplackschicht 5 auf eine Oberfläche des ersten Anschlussträgers 1 aufgebracht und mittels einer Fototechnik strukturiert. Die mittels der Fototechnik in die Lötstopplackschicht 5 strukturierten Ausnehmungen bilden dann die Befestigungsbereiche 2, die im folgenden Verlauf des Verfahrens das Lotmaterial 3 aufnehmen.

Anhand der schematischen Perspektivdarstellung der Figur 3B ist erläutert, dass in einem nachfolgenden Verfahrensschritt Lotmaterial 3 in die Befestigungsbereiche 2 eingebracht wird.

In Verbindung mit der Figur 3C ist ein weiterer Verfahrensschritt des dritten Ausführungsbeispiels eines hier beschriebenen Verfahrens erläutert. In diesem Verfahrensschritt wird ein zweiter Anschlussträger 4 auf die Befestigungsbereiche 2 mit dem Lotmaterial 3 aufgebracht. Bei dem zweiten Anschlussträger 4 handelt es sich vorliegend um einen Anschlussträger mit einem keramischen Grundkörper, auf dem Leiterbahnen 11 strukturiert sind. Auf den zweiten Anschlussträger 4 sind bereits optoelektronische Bauelemente 10 wie zum Beispiel Leuchtdiodenchips aufgebracht.

Anhand der Figur 3D ist ein weiterer Verfahrensschritt des dritten Ausführungsbeispiels eines hier beschriebenen Verfahrens zur Herstellung einer Anordnung optoelektronischer Bauelemente erläutert. In diesem Verfahrensschritt wird der aufgesetzte zweite Anschlussträger 4 mit Flussmittel fixiert und beispielsweise mittels einer Reflow-Löttechnik auf den ersten Anschlussträger 1 aufgelötet. Dabei wird die mechanische Verbindung zwischen dem ersten Anschlussträger 1 und dem zweiten Anschlussträger 4 durch das Lotmaterial in den Befestigungsbereichen 2 vermittelt.

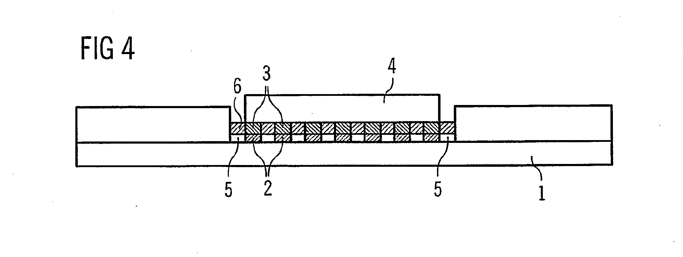

Die Figur 4 zeigt in einer schematischen Schnittdarstellung eine hier beschriebene Anordnung optoelektronischer Bauelemente entlang des Schnittes AA', wie er in Figur 3D gezeigt ist. In diesem Ausführungsbeispiel sind die Befestigungsbereiche 2 durch Ausnehmungen in einer Lötstopplackschicht 5 gebildet. Die Ausnehmungen sind mit Lotmaterial 3 befüllt. Das Lotmaterial 3 ist seitlich von einem nicht adhäsiven Füllmaterial 6 umhüllt, das eine thermisch leitende Verbindung zwischen dem ersten Anschlussträger 1 und dem zweiten Anschlussträger 4 vermittelt. Die mechanische Verbindung zwischen dem ersten Anschlussträger 1 und dem zweiten Anschlussträger 4 wird dabei durch das Lotmaterial 3 in den Befestigungsbereichen 2 vermittelt. Insbesondere schließt das Lotmaterial 3 optoelektronische Bauelemente 10 auf dem zweiten Anschlussträger nicht elektrisch an den ersten Anschlussträger 1 an. Das heißt das Lotmaterial 3 ist nicht zur Kontaktierung der optoelektronischen Bauelemente 10 vorgesehen.

Alternativ ist es aber auch möglich, dass das Füllmaterial 6 adhäsiv ist und zusätzlich zum Lotmaterial 3 eine weitere mechanische Verbindung zwischen den Anschlussträgern 1, 4 vermittelt.

## Patentansprüche

1. Verfahren zur Herstellung einer Anordnung optoelektronischer Bauelemente (10) mit den folgenden Schritten:
- Herstellen von zumindest zwei Befestigungsbereichen (2) auf einem ersten Anschlussträger (1);
- Einbringen von Lotmaterial (3) in die Befestigungsbereiche (2);
- Aufbringen eines zweiten Anschlussträgers (4), der eine Leiterplatte ist, auf die Befestigungsbereiche (2); und
- Auflöten des zweiten Anschlussträgers (4) auf den ersten Anschlussträger (1) mit dem Lotmaterial (3) in den Befestigungsbereichen (2), wobei
zumindest ein optoelektronisches Bauelement (10) auf die dem ersten Anschlussträger (1) abgewandte Seite des zweiten Anschlussträgers (4) aufgebracht wird und das Lotmaterial (3) in den Befestigungsbereichen (2) nicht zum elektrischen Anschließen des zumindest einen optoelektronischen Bauelements (10) dient.

2. Verfahren nach dem vorherigen Anspruch,
wobei zumindest ein Befestigungsbereich (2) durch das Erzeugen einer Ausnehmung im ersten Anschlussträger (1) hergestellt wird.

3. Verfahren nach zumindest einem der vorherigen Ansprüche, wobei zumindest ein Befestigungsbereich (2) durch das Aufbringen einer Metallisierung auf den ersten Anschlussträger (1) hergestellt wird.

4. Verfahren nach zumindest einem der vorherigen Ansprüche, wobei zumindest ein Befestigungsbereich (2) durch das Strukturieren einer Lötstoppschicht (5), die auf den ersten Anschlussträger aufgebracht ist, hergestellt wird.

5. Verfahren nach zumindest einem der vorherigen Ansprüche, wobei die Befestigungsbereiche (2) matrixartig angeordnet werden.

6. Verfahren nach zumindest einem der vorherigen Ansprüche, wobei das Lotmaterial (3) in den Befestigungsbereichen (2) vor Aufbringen des zweiten Anschlussträgers (4) planarisiert wird.

7. Verfahren nach zumindest einem der vorherigen Ansprüche, wobei zwischen dem ersten (1) und dem zweiten Anschlussträger (4) ein Füllmaterial (6) eingebracht wird, welches das Lotmaterial (3) zumindest stellenweise seitlich umhüllt.

8. Verfahren nach dem vorherigen Anspruch,
wobei das Füllmaterial (6) nicht-adhäsiv ist.

9. Verfahren nach Anspruch 7,
wobei das Füllmaterial (6) adhäsiv ist.

10. Verfahren nach zumindest einem der vorherigen Ansprüche, wobei vor dem Aufbringen des zweiten Anschlussträgers (4) auf die Befestigungsbereiche (2) zumindest ein optoelektronisches Bauelement (10) auf den zweiten Anschlussträger aufgebracht wird.

11. Anordnung optoelektronischer Bauelemente (10) mit
- einem ersten Anschlussträger (1), der zumindest zwei Befestigungsbereiche (2) aufweist, in die ein Lotmaterial (3) eingebracht ist,
- einem zweiten Anschlussträger (4), der eine Leiterplatte ist und durch das Lotmaterial (3) in den Befestigungsbereichen (2) mechanisch mit dem ersten Anschlussträger (1) verbunden ist, und
- zumindest einem optoelektronischen Bauelement (10), das auf die dem ersten Anschlussträger (1) abgewandte Seite des zweiten Anschlussträgers (4) aufgebracht ist, wobei das Lotmaterial (3) in den Befestigungsbereichen (2) nicht zum elektrischen Anschließen des zumindest einen optoelektronischen Bauelements (10) dient.

12. Anordnung nach dem vorherigen Anspruch, bei der sich zwischen dem ersten Anschlussträger (1) und dem zweiten Anschlussträger (4) ein Füllmaterial(6) befindet, welches das Lotmaterial (3) zumindest stellenweise seitlich umhüllt.

13. Anordnung nach dem vorherigen Anspruch, bei der das Füllmaterial(6) das Lotmaterial (3) vollständig seitlich umhüllt.

14. Anordnung nach zumindest einem der vorherigen Ansprüche 11 bis 13, bei der der erste Anschlussträger (1) durch eine Leiterplatte gebildet ist.

## Claims

1. Method for producing an arrangement of optoelectronic components (10), comprising the following steps:
- producing at least two fixing regions (2) on a first connection carrier (1);
- introducing solder material (3) into the fixing regions (2);
- applying a second connection carrier (4), which is a printed circuit board, to the fixing regions (2); and
- soldering the second connection carrier (4) onto the first connection carrier (1) with the solder material (3) in the fixing regions (2), wherein
at least one optoelectronic component (10) is applied to that side of the second connection carrier (4) which is remote from the first connection carrier (1) and the solder material (3) in the fixing regions (2) does not serve for the electrical connection of the at least one optoelectronic component (10).

2. Method according to the preceding claim,
wherein at least one fixing region (2) is produced by producing a cutout in the first connection carrier (1).

3. Method according to at least one of the preceding claims,
wherein at least one fixing region (2) is produced by applying a metalization to the first connection carrier (1).

4. Method according to at least one of the preceding claims,
wherein at least one fixing region (2) is produced by patterning a soldering resist layer (5) applied to the first connection carrier.

5. Method according to at least one of the preceding claims,
wherein the fixing regions (2) are arranged in matrix-like fashion.

6. Method according to at least one of the preceding claims,
wherein the solder material (3) in the fixing regions (2) is planarized before the second connection carrier (4) is applied.

7. Method according to at least one of the preceding claims,
wherein a filling material (6) is introduced between the first (1) and the second connection carrier (4), said filling material laterally enveloping the solder material (3) at least in places.

8. Method according to the preceding claim,
wherein the filling material (6) is non-adhesive.

9. Method according to Claim 7,
wherein the filling material (6) is adhesive.

10. Method according to at least one of the preceding claims,
wherein before the second connection carrier (4) is applied to the fixing regions (2), at least one optoelectronic component (10) is applied to the second connection carrier.

11. Arrangement of optoelectronic components (10) comprising
- a first connection carrier (1), which has at least two fixing regions (2) into which a solder material (3) is introduced,
- a second connection carrier (4), which is a printed circuit board and is mechanically connected to the first connection carrier (1) by the solder material (3) in the fixing regions (2), and
- at least one optoelectronic component (10) applied to that side of the second connection carrier (4) which is remote from the first connection carrier (1), wherein the solder material (3) in the fixing regions (2) does not serve for the electrical connection of the at least one optoelectronic component (10).

12. Arrangement according to the preceding claim,
wherein a filling material (6) is situated between the first connection carrier (1) and the second connection carrier (4), said filling material laterally enveloping the solder material (3) at least in places.

13. Arrangement according to the preceding claim,
wherein the filling material (6) laterally envelops the solder material (3) completely.

14. Arrangement according to at least one of the preceding Claims 11 to 13,
wherein the first connection carrier (1) is formed by a printed circuit board.

## Revendications

1. Procédé de fabrication d'un ensemble de composants optoélectroniques (10), le procédé comportant les étapes suivantes :
fabrication d'au moins deux parties de fixation (2) sur un premier porte-borne (1),
insertion de matériau de brasure (3) dans les parties de fixation (2),
application d'un deuxième porte-borne (4) qui est une carte de circuit sur les parties de fixation (2) et
brasage du deuxième porte-borne (4) sur le premier porte-borne (1) à l'aide de matériau de brasage (3) placé dans les parties de fixation (2),
au moins un composant optoélectronique (10) étant placé sur le côté du deuxième porte-borne (4) non tourné vers le premier porte-borne (1) et le matériau de brasage (3) placé dans les parties de fixation (2) ne servant pas au raccordement électrique du ou des composants optoélectroniques (10).

2. Procédé selon la revendication précédente, dans lequel au moins une partie de fixation (2) est formée par formation d'une découpe dans le premier porte-borne (1).

3. Procédé selon au moins l'une des revendications précédentes, dans lequel au moins une partie de fixation (2) est réalisée par application d'une métallisation sur le premier porte-borne (1).

4. Procédé selon au moins l'une des revendications précédentes, dans lequel au moins une partie de fixation (2) est réalisée par la structuration d'une couche (5) d'arrêt de brasure appliquée sur le premier porte-borne.

5. Procédé selon au moins l'une des revendications précédentes, dans lequel les parties de fixation (2) sont disposées en matrice.

6. Procédé selon au moins l'une des revendications précédentes, dans lequel le matériau de brasage (3) apporté dans les parties de fixation (2) est plané avant le placement du deuxième porte-borne (4).

7. Procédé selon au moins l'une des revendications précédentes, dans lequel un matériau de charge (6) qui entoure latéralement au moins certaines parties du matériau de brasage (3) est placé entre le premier porte-borne (1) et le deuxième porte-borne (4).

8. Procédé selon la revendication précédente, dans lequel le matériau de charge (6) n'est pas adhésif.

9. Procédé selon la revendication 7, dans lequel le matériau de charge (6) est adhésif.

10. Procédé selon au moins l'une des revendications précédentes, dans lequel au moins un composant optoélectronique (10) est placé sur le deuxième porte-borne avant le placement du deuxième porte-borne (4) sur les parties de fixation (2).

11. Ensemble de composants optoélectroniques (10) présentant
un premier porte-borne (1) qui présente au moins deux parties de fixation (2) dans lesquelles un matériau de brasage (3) est placé,
un deuxième porte-borne (4) qui est une carte de circuit et qui est relié mécaniquement au premier porte-borne (1) par le matériau de brasage (3) apporté dans les parties de fixation (2),
au moins un composant optoélectronique (10) placé sur le côté du deuxième porte-borne (4) non tourné vers le premier porte-borne (1), dans lequel
le matériau de brasage (3) présent dans les parties de fixation (2) ne servant pas au raccordement électrique du ou des composants électroniques (10).

12. Ensemble selon la revendication précédente, dans lequel un matériau de charge (6) qui entoure latéralement au moins certaines parties du matériau de brasage (3) est placé entre le premier porte-borne (1) et le deuxième porte-borne (4).

13. Ensemble selon la revendication précédente, dans lequel le matériau de charge (6) entoure latéralement et complètement le matériau de brasage (3).

14. Ensemble selon au moins l'une des revendications 11 à 13 qui précèdent, dans lequel le premier porte-borne (1) est formé par une carte de circuit.
